# EUROPÄISCHE PATENTSCHRIFT

(11) **EP 0 394 692 B1**
(45) Veröffentlichungstag und Bekanntmachung des Hinweises auf die Patenterteilung: **08.06.1994**
(21) Anmeldenummer: 90105981.6
(22) Anmeldetag: 29.03.1990
(51) Int. Cl.: C23C 14/22, C23C 14/32, C23C 14/34, C23C 16/50

(54) **Verfahren und Vorrichtung zum Beschichten eines Substrates in einem Plasma**
Process and apparatus for coating a substrate in a plasma
Procédé et dispositif pour revêtir un substrat dans un plasma

(30) Priorität: 26.04.1989 DE 3913716
(43) Veröffentlichungstag der Anmeldung: 31.10.1990
(73) Patentinhaber: FRAUNHOFER-GESELLSCHAFT ZUR FÖRDERUNG DER ANGEWANDTEN FORSCHUNG E.V., 80636 München (DE)
(72) Erfinder: Zeller, Rolf, D-7801 Umkirch (DE)
(74) Vertreter: Rackette, Karl, Dipl.-Phys. Dr.-Ing

(56) Entgegenhaltungen:
- WO-A-84/04761
- GB-A- 2 092 182
- US-A- 4 406 765
- US-A- 4 505 949
- PATENT ABSTRACTS OF JAPAN, Band 6, Nr. 250 (C-139)[1128], 9. Dezember 1982; & JP-A-57 145 984 (NIPPON SHINKU GIJUTSU K.K.) 09-09-1982

## Beschreibung

Die Erfindung betrifft ein Verfahren zum Beschichten eines Substrates in einem Plasma, bei dem zum Transport nichtflüchtiger Substanzen in das Plasma einer abgeschlossenen Vakuumkammer in räumlicher Entfernung von der Anode das zu beschichtende Substrat als eine erste Kathode und eine zweite Kathode aus der zu transportierenden nichtflüchtigen Substanz als Verflüchtigungselektrode vorgesehen sind sowie eine Vorrichtung zur Durchführung des Verfahrens.

Eine Vorrichtung zur Durchführung eines solchen Verfahrens ist aus der US-PS 4 731 539 bekannt, mit der Metalle in die obersten Schichten der Oberfläche eines Substrates eingebracht werden können. Die metallische Verflüchtigungselektrode der bekannten Vorrichtung wird mittels eines Wechselstroms stark aufgeheizt. Bei einer hohen, etwas unter dem Schmelzpunkt des Metalles der Verflüchtigungselektrode liegenden Temperatur werden Metallionen und -atome aus dem Metalldraht der Verflüchtigungselektrode herausgelöst, die in der Vakuumkammer zu dem zu beschichtenden Substrat diffundieren, in der dortigen Glimmentladung die Oberfläche des Substrates bombardieren und in die obersten Schichten der Substratoberfläche eingelagert werden. Das beim Betreiben der bekannten Vorrichtung eingesetzte Verfahren weist den Nachteil auf, daß Substrate nur mit Metallen und deren Legierungen beschichtet werden können.

Der Artikel "Hartstoffbeschichtung mit dem Plasma-CVD-Verfahren" von H.R. Stock und P. Mayr, Seiten 145 - 151, aus HTM 41 (1986) lehrt ein Chemical-Vapour-Deposition Verfahren, kurz CVD-Verfahren, um Substrate mit Schichten aus TiC, TiN, Al₂O₃ zu versehen. Für Beschichtungen aus TiN wird nichtflüchtiges Titan in Form einer flüchtigen Verbindung wie TiCl₄ an die Werkstoffoberfläche herangebracht und bei einer hohen Temperatur mit einem Reaktionspartner, in diesem Falle N₂, zu der benötigten Verbindung umgesetzt. Die bei üblichen technischen CVD-Prozesse benötigten Temperaturen liegen im Bereich von 1000 Grad Celsius.

Um solche den Grundwerkstoff der Werkstücke meist unerwünscht beeinflussenden hohen Temperaturen zu vermeiden, werden häufig plasmaunterstützte CVD-Prozesse benutzt. Bei derartigen Verfahren werden im Glimmentladungs- oder HF- oder Mikrowellenplasma angeregte Zustände der an der Reaktion beteiligten Atome erzeugt, so daß eine hinreichende Reaktionsgeschwindigkeit zur Bildung der CVD-Schicht auch bei niedrigeren Temperaturen vorliegt. Jedoch weisen derartige Plasma-CVD-Verfahren den Nachteil auf, daß die zum Aufbau von CVD-Schichten benötigten flüchtigen Transportverbindungen hochtoxisch, ätzend, selbstentzündlich, korrosiv oder schwer handhabbar sind. Eine selbstentzündliche Transportverbindung ist zum Beispiel Silan ( SiH₄ ). Diboran ( B₂H₆ ) ist hochtoxisch, während Titan-Tetra-Chlorid ( TiCl₄ ) zu Korrosionserscheinungen in der Beschichtungsvorrichtung führt.

Die US-PS 4 505 949 lehrt eine solche Vorrichtung, bei der eine benötigte Transportverbindung in einem besonderen Plasmareaktionsbereich der Vakuumkammer mit Hilfe eines reaktionsgasdurchströmten Parallelplattenreaktors erzeugt wird. Die synthetisierte Transportverbindung wird anschließend in räumlicher Nähe des Substrates durch die Einwirkung von Laserstrahlung zerlegt und der Metallanteil auf dem Substrat abgeschieden. Das Targetmaterial bildet die Anode des Parallelplattenreaktors, der an eine Gleichspannungs- oder Wechselspannungsversorgung angeschlossen ist. Diese bekannte Vorrichtung gestattet nicht die großflächige Beschichtung von Substraten mit Schichten größerer Dicke und insbesondere nicht die Beschichtung von unregelmäßig geformten Werkstücken.

Die US-PS 4 683 838 beschreibt eine Beschichtungsvorrichtung, bei der ein mit Hilfe von Mikrowellen erzeugter Plasmastrom mit einem Metalldampfstrom gekreuzt wird, wodurch in der Kreuzungszone die abzuscheidende Substanz durch eine Reaktion der Metallatome mit den Plasmaionen synthetisiert wird, die sich in der Folge auf dem zu beschichtenden Substrat niederschlägt. Hierbei handelt es sich um einen PVD-(Physical-Vapour-Deposition)-Prozeß, der nur eine gleichmäßige Beschichtung von im wesentlichen ebenen Substraten gestattet.

Aus der US-PS 4 226 896 ist eine Vorrichtung zur Plasmapolymerisation bekannt, bei der das zu beschichtende Substrat in einer im wesentlichen regelmäßig geformten ersten Elektrode und ein Beschichtungsmetall in einer zu dieser ersten Elektrode gemäß Spalte 2, Zeilen 8 bis 10 koplanar oder kosphärisch verlaufenden Metallelektrode vorliegt. Mit Hilfe einer einzigen Hauptentladung in der Vakuumkammer wird das Metall aus der Metallelektrode herausgelöst, mit einem durchströmenden Gas zur Reaktion gebracht und in einer weiteren Reaktion auf dem Substrat in einem Polymer abgesetzt. Die Vorrichtung ist nur zur Herstellung metallhaltiger Polymerschichten bei koaxial oder koplanar verlaufenden Elektroden geeignet.

Die US-PS 4 668 366 lehrt ein Verfahren zum Oberflächengestalten der Oberfläche eines Werkstückes, wobei eine Vorrichtung zur Durchführung des Verfahrens über eine kleinflächige, bewegliche Elektrode verfügt, die jeweils nur einen kleinen Anteil des zu bearbeitenden, elektrisch isolierenden Werkstückes kontaktiert. An der im Vergleich zur Gegenelektrode wesentlich kleineren Elektrodenfläche geht die Plasmaabscheidung in eine Plasmaätzung über, so daß die Dauer der an einer vorbestimmten Stelle durch die kleine Elektrode auftretenden Gasentladung die Oberflächenform des Werkstückes an dieser Stelle bestimmt. Mit einer solchen Vorrichtung ist das Beschichten unregelmäßig geformter Werkstücke, bei denen zu beschichtende Kugelabschnitte sogar einander gegenüberliegende Anteile aufweisen, nicht möglich.

Die GB-A-20 92 182 betrifft eine Sputter-Apparatur und somit ein PVD-Verfahren. Dabei kommt eine einem Sieb-Target ähnliche Einrichtung zum Einsatz, mit der ein zum Substrat hin fallender Druckgradient erzeugbar ist, der für das PVD-Verfahren vorteilhaft ist.

Die US-PS 4 406 765 beschreibt eine Vorrichtung zur Plasma-Dekomposition zur Herstellung amorpher Halbleiterschichten, wobei die chemische Transportverbindung am Schichtbildungsort zersetzt wird.

Die JP-A-57 145 984 lehrt eine Vorrichtung zur Verbesserung von Sputterraten von ferromagnetischen Substanzen, bei der in V-förmigen Kerben ein starkes magnetisches Streufeld erzeugbar ist, welches einen verbesserten Targetabtrag gestattet. Es handelt sich um ein Gerät für ein PVD-Verfahren, welches zudem nur bei ferromagnetischen Substanzen einsetzbar ist.

Ausgehend von diesem Stand der Technik liegt der Erfindung die Aufgabe zugrunde, ein Verfahren und eine Vorrichtung der eingangs genannten Art zu schaffen, die es gestatten, hohe Verflüchtigungsraten zur Plasma-CVD-Beschichtung großer, unregelmäßig geformter Werkstücke zu erreichen und mit dem Substrate ohne externes Zuführen gefährlicher Stoffe auch mit Stoffen beschichtet werden können, die Nichtmetallverbindungen sind.

Erfindungsgemäß wird die Aufgabe für ein Verfahren mit den eingangs genannten Merkmalen gelöst durch die Verfahrensschritte
- des Evakuierens der Vakuumkammer und Einleitens eines Trägergases in die Vakuumkammer bei einem Druck von unter 1 kPa (10 mbar);
- des Einleitens eines Reaktivgases in die Vakuumkammer;
- des Erzeugens einer Potentialdifferenz zwischen der Anode und der ersten Kathode, um eine Hauptglimmentladung zu schaffen;
- des Erzeugens einer Potentialdifferenz zwischen der Anode und der zweiten Kathode, um eine Nebenglimmentladung zu schaffen; und
- des Umspülens der Verflüchtigungselektrode mit einem Gasgemisch aus einem Reaktionsgas und dem Trägergas, wobei die vom Trägergas in der Nebenglimmentladung aus der Verflüchtigungselektrode herausgelöste nichtflüchtige Substanz in einer chemischen Transportverbindung mit dem Reaktionsgas zu dem Substrat transportiert wird und im dortigen Plasma das Substrat mit einer chemischen Beschichtungsverbindung aus der nichtflüchtigen Substanz mit dem Reaktivgas beschichtet wird.

Eine zur Durchführung des Verfahrens geeignete Vorrichtung ist im Patentanspruch 15, im Patentanspruch 20 und im Patentanspruch 21 gekennzeichnet.

Dadurch, daß die als gesonderte zweite Kathode vorgesehene Verflüchtigungselektrode aus dem zu transportierenden Stoff von dem Trägergas umspült wird, das Komponenten enthält, die mit dem Targetmaterial der Verflüchtigungselektrode in einer Nebenglimmentladung eine flüchtige Verbindung eingehen, kann die möglicherweise gefährliche Transportverbindung innerhalb des Rezipienten der Vakuumkammer synthetisiert werden.

Bei einem bevorzugten Ausführungsbeispiel durchströmt das Trägergas Bohrungen eines durchbohrten Targets der Verflüchtigungselektrode, so daß eine verläßliche Nebenglimmentladung in den Bohrungen entzündbar ist.

Alternativ zu einer durchbohrten Verflüchtigungselektrode kann eine gefurchte Oberfläche des Targets mit dem Gasgemisch aus Trägergas und Reaktionsgas angeblasen werden, wobei in der in den Furchen brennenden Nebenglimmentladung, deren Potentialabfall im wesentlichen in den Furchen stattfindet, die Transportverbindung synthetisiert wird.

Weitere vorteilhafte Ausgestaltungen der Erfindung sind in den Unteransprüchen gekennzeichnet.

Nachfolgend werden Ausführungsbeispiele der Erfindung anhand der Zeichnung näher erläutert. Es zeigen:
- Fig. 1: eine schematische Querschnittsansicht einer Vorrichtung zum Hartstoffbeschichten eines Substrates gemäß einem ersten Ausführungsbeispiel,
- Fig. 2: eine Verflüchtigungselektrode gemäß dem ersten Ausführungsbeispiel der Erfindung,
- Fig. 3: eine schematische Querschnittsansicht einer Vorrichtung zum Hartstoffbeschichten eines Substrates gemäß einem zweiten Ausführungsbeispiel,
- Fig. 4: eine Verflüchtigungselektrode gemäß dem zweiten Ausführungsbeispiel der Erfindung, und
- Fig. 5: eine Verflüchtigungselektrode gemäß einem dritten Ausführungsbeispiel der Erfindung.

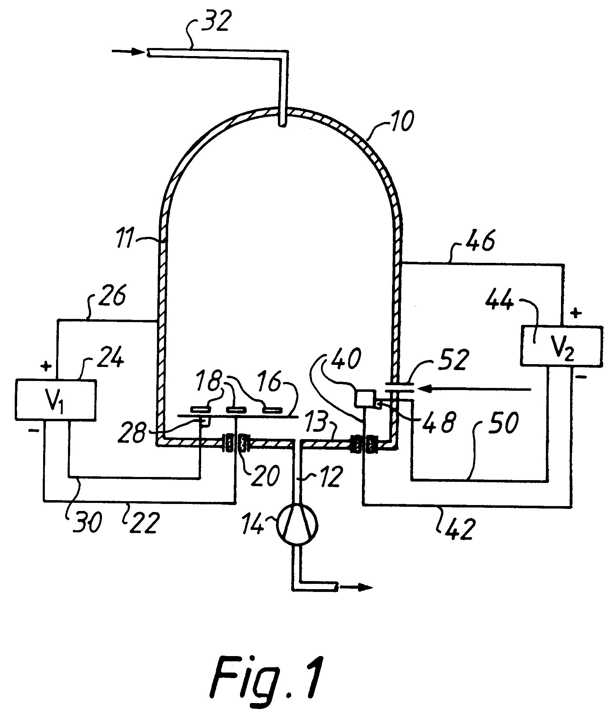

Die Fig. 1 zeigt eine schematische Querschnittsansicht einer Vorrichtung zum Hartstoffbeschichten gemäß einem ersten Ausführungsbeispiel. Die Vorrichtung verfügt über eine Vakuumkammer 10 aus Metall, die über eine Evakuierleitung 12 an eine Vakuumpumpe 14 angeschlossen ist. Mit Hilfe der Vakuumpumpe 14 wird die Vakuumkammer 10 auf einen Druckbereich von ungefähr 50 bis 2000 Pa (0,5 bis 20 mbar) evakuiert. Die Evakuierleitung 12 kann von einer in der Fig. 1 nicht gezeichneten Kühlfalle umgeben sein, mit deren Hilfe korrosive, ätzende oder toxische Verbindungen abgeschieden werden können, um zu verhindern, daß diese über die Vakuumpumpe 14 in die Umgebungsluft gelangen.

In der Vakuumkammer 10 ist im Abstand von und entlang deren Boden 13 eine Chargierplatte 16 angeordnet, auf der zu beschichtende Substrate 18 aus einem elektrisch leitenden Material aufgelegt sind. Die Chargierplatte 16 weist einen größeren Abstand zu der Wandung der Vakuumkammer 10 auf, von der sie elektrisch isoliert ist. Die Chargierplatte 16 ist auf einer Chargierelektrodendurchführung 20 montiert, die isoliert von der Wand 11 der Vakuumkammer 10 durch deren Boden 13 hindurchgeführt ist. Die Chargierelektrodendurchführung 20 ist über die Chargierkathodenleitung 22 mit dem negativen Pol einer Entladungsspannungsquelle 24 verbunden. Der positive Pol der Entladungsspannungsquelle 24 ist über eine Entladungsanodenleitung 26 elektrisch an das metallische Gehäuse der Vakuumkammer 10 angeschlossen.

Die Spannung der Entladungsspannungsquelle 24 ist zwischen 200 und 1000 Volt Gleichspannung regelbar. Diese Potentialdifferenz liegt zwischen dem Gehäuse 11 der Vakuumkammer 10 einerseits und der Chargierplatte 16 und den mit ihr in leitender Verbindung stehenden Werkstücken 18 andererseits an. Die Potentialdifferenz erzeugt eine Hauptglimmentladung, bei der das negative Glimmlicht in unmittelbarer Umgebung der Substrate 18 und der Chargierplatte 16 auftritt. Fast die gesamte Spannung zwischen dem Gehäuse 11 der Vakuumkammer 10 und den Substraten 18 beziehungsweise der Chargierplatte 16 fällt im Bereich des negativen Glimmlichts und des wenige freie Weglängen hohen Dunkelraums über den Substraten 18 ab.

Die bis zu 30 Ampere belastbare Entladungsspannungsquelle 24 arbeitet vorzugsweise im Pulsbetrieb. Die Impulsdauern liegen dabei im Bereich von 20 bis 1000 Mikrosekunden, die sich mit Pausendauern zwischen 20 und 1000 Mikrosekunden abwechseln.

Die auftretende Entladung führt zu einer Erwärmung der Substrate 18 und der Chargierplatte 16, die von einem Substratthermofühler 28 detektiert wird. Der Substratthermofühler 28 ist über eine Signalleitung 30, die isoliert durch das Gehäuse 11 der Vakuumkammer 10 hindurchgeführt ist, mit der Entladungsspannungsquelle 24 verbunden. Die Entladungsspannungsquelle 24 umfaßt eine Temperaturregelung, die die Temperatur der Substrate 18 auf eine vorbestimmte Temperatur regelt. Zur Erhöhung der Temperatur der Substrate 18 verkürzt die Temperaturregelung in der Entladungsspannungsquelle 24 die Pausendauern.

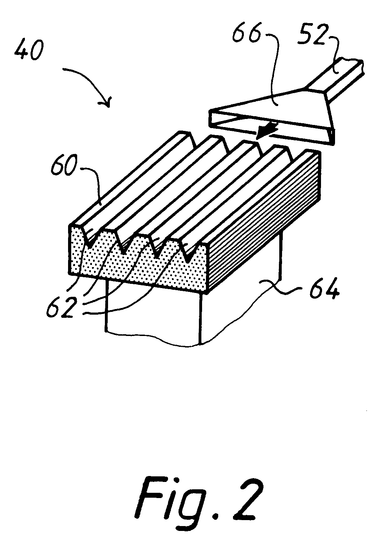

Der oben genannte Druck von 50 bis 2000 Pa (0,5 bis 20 mbar) in der Vakuumkammer 10 ist die Folge eines Fließgleichgewichtes. Über eine Reaktivgasleitung 32 wird ein Reaktivgas in die Vakuumkammer geleitet. Mögliche Reaktivgase sind in der im Zusammenhang mit der Fig. 2 genannten Tabelle zu entnehmen. Das Reaktivgas wird in einem konstanten Gasstrom der Vakuumkammer 10 zugeführt.

Desweiteren ist in der Vakuumkammer 10 eine Verflüchtigungselektrode 40 angeordnet, die sich elektrisch von der Vakuumkammer 10 isoliert durch den Boden 13 der Vakuumkammer 10 hindurcherstreckt. Die Verflüchtigungselektrode 40 ist über eine Verflüchtigungskathodenleitung 42 mit dem Minuspol einer Verflüchtigungsspannungsquelle 44 verbunden. Der Pluspol der Verflüchtigungsspannungsquelle 44 ist über eine Verflüchtigungsanodenleitung 46 an das metallische Gehäuse 11 der Vakuumkammer 10 angeschlossen. Die Spannung der Verflüchtigungsspannungsquelle 44 ist zwischen 200 und 1000 Volt regelbar und mit mehr als 5 Ampere belastbar. Durch eine derartige Anordnung wird eine Nebenglimmentladung zwischen der Verflüchtigungselektrode 40 und der Vakuumkammer 10 erzeugt, bei der sich die Verflüchtigungselektrode 40 erhitzt. Die Temperatur der Verflüchtigungselektrode 40 wird mit Hilfe eines Verflüchtigungsthermofühlers 48 erfaßt und über eine Signalleitung 50 durch das Gehäuse 11 der Vakuumkammer 10 hindurch zur Verflüchtigungsspannungsquelle 44 geleitet, die über eine Temperaturregelungseinrichtung verfügt.

Bei einem Impulsbetrieb mit Pulsdauern zwischen 20 und 1000 Mikrosekunden wird die Temperatur der Verflüchtigungselektrode 40 über eine Veränderung der Pausendauern der Nebenglimmentladung geregelt.

Die Zündung der Nebenglimmentladung durch eine separate Verflüchtigungsspannungsquelle 44 gestattet eine einfache Regelung der Menge der erzeugten Transportverbindung und die Regelung der Temperatur der Verflüchtigungselektrode 40, um diese vor einer Überhitzung zu schützen.

Der Impulsbetrieb der die Verflüchtigungselektrode 40 speisenden Verflüchtigungsspannungsquelle 44 mit einer gepulsten Gleichspannung gestattet eine intensive Zerstäubung innerhalb der Glimmentladung, da die Zerstäubungsrate von der Höhe der Entladungsspannung abhängt.

Über eine Reaktions- und Trägergasleitung 52 wird das Kopfstück der Verflüchtigungselektrode 40 mit einem Reaktionsgas und einem Trägergas umspült. Das Trägergas ist vorzugsweise Argon oder ein anderes Edelgas und mögliche Reaktionsgase sind in der Tabelle zu Fig. 2 aufgeführt. Das Gasgemisch aus dem Reaktionsgas und dem Trägergas wird in einem konstanten Gasstrom der Vakuumkammer 10 zugeführt.

Obwohl innerhalb der Vakuumkammer 10 ein relativ hoher Druck von z.B. 500 Pa (5 mbar) herrscht, ist bei der Auslegung der Vakuumdurchführungen sowie der Gasleitungen und deren Ventile auf eine hohe Gasdichtigkeit zu achten, damit kein Sauerstoff in das Innere der Vakuumkammer 10 eindringt. Bei der Erzeugung von Quarz als Beschichtungsmaterial für die Substrate 18 ist dies jedoch nicht notwendig.

Die Fig. 2 zeigt vergrößert und in einer perspektivischen Ansicht das Kopfende der Verflüchtigungselektrode 40 der in Fig. 1 insgesamt dargestellten Vorrichtung. Die Verflüchtigungselektrode 40 verfügt über einen Targetkopf 60, der aus einem Element für das vorgesehene Schichtmaterial besteht, das mit Hilfe der in der Vakuumkammer 10 erzeugten Transportverbindung chemisch an die Substrate 18 herantransportiert wird. Der Targetkopf 60 weist eine Vielzahl von in Richtung des aus der Reaktions- und Trägergasleitung 52 ausströmenden Gases parallel nebeneinander verlaufenden Furchen 62 auf, die sich quer zur Strömungsrichtung des Gases verengen oder spitz zulaufen, so daß in der Querschnittsansicht jeweils Dreiecke entstehen.

Der Targetkopf 60 ist auf einem leitenden Fußteil 64 montiert, das nach seiner Durchführung durch den Boden 13 der Vakuumkammer 10 in die Verflüchtigungselektrodenkathodenleitung 42 übergeht. Der Targetkopf 60 ist somit elektrisch mit dem Minuspol der Verflüchtigungsspannungsquelle 44 verbunden. Die Austrittsöffnung der Reaktions- und Trägergasleitung 52 ist fluchtend mit den Furchen 62 des Targetkopfs 60 angeordnet. Die Reaktions- und Trägergasleitung 52 geht in einen Verteilertrichter 66 über, dessen Querschnitt sich von dem Querschnitt der Reaktions- und Trägergasleitung 52 zur Breite des Targetkopfs 60 vergrößert. Die Höhe des Verteilertrichters 66 ist in der Größenordnung der Tiefe der Furchen 62.

Der Verteilertrichter 66 ist derart angeordnet, daß das durch ihn hindurchströmende Reaktionsgas und Trägergas in den Furchen 62 entlang denselben strömt. Bei einer Abwandlung der Ausführungsform des Verteilertrichters 66 ist seine mit der Achse der Trägergasleitung 52 übereinstimmende Hauptachse leicht gegen die Ebene der Furchen 62 derart geneigt, daß die Furchen 62 leicht von oben angeblasen werden.

Die nachfolgende Tabelle zeigt eine Auswahl von möglichen Targetmaterialien, die von dem Gasgemisch der dargestellten Reaktions- und Trägergase umspült werden. Das Gasgemisch geht in der Nebenglimmentladung in der Nähe der Verflüchtigungselektrode 40 eine Transportverbindung ein, die sich in der Hauptglimmentladung in der Nähe der Substrate 18 mit dem Reaktivgas in das Schichtmaterial umwandelt. Das Trägergas, das vorzugsweise Argon ist, ist in der Tabelle nicht aufgeführt.

| Target material | Reaktionsgas | Transportverbindung | Reaktivgas | Schichtmaterial |
|---|---|---|---|---|
| Si | H₂ | SiH₄ | N₂ | Si₃N₄ |
| Si | H₂ | SiH₄ | CH₄ | SiC |
| Si | H₂ | SiH₄ | O₂ | SiO₂ |
| B | H₂ | B₂H₆ | N₂ | CBN |
| B | H₂ | B₂H₆ | CH₄ | B₄C |
| Ni | CO₂+CH₄ | Ni(CO)₄ | | Ni |
| Cr | CO₂+CH₄ | Cr(CO)₄ | CH₄ | Cr₇C₃ |

Die Namen der vorbenannten Verbindungen sind: Silan für SiH₄, Diboran für B₂H₆, Methan für CH₄, Kohlendioxid für CO₂, Nickeltetracarbonyl für Ni(CO)₄, Chromtetracarbonyl für Cr(CO)₄, Siliziumnitrid für Si₃N₄, Siliziumcarbid für SiC, Quarz oder Siliziumdioxid für SiO₂, kubisches Bornitrid für CBN, Borkarbid für B₄C und Chromkarbid für Cr₇C₃.

Beispielhaft wird im folgenden die Erzeugung einer Schicht aus Siliziumnitrid (Si₃N₄) beschrieben. Das Targetmaterial des Targetkopfs 60 besteht aus Silizium. Zwischen dem Gehäuse 11 der Vakuumkammer 10 und dem Targetkopf 60 besteht eine große Potentialdifferenz, die bei dem herrschenden Druck zu einer Hohlkathodenentladung in den Furchen 62 des Targetkopfs 60 führt. Durch den Verteilertrichter 66 hindurch wird als Reaktionsgas Wasserstoff und als Trägergas Argon eingeleitet. Die schweren Argonatome schlagen Siliziumatome aus dem Targetmaterial des Targetkopfs 60 heraus, die sich im Plasma der Entladung aufgrund der angeregten Zustände mit den Atomen des als Reaktionsgas verwendeten Wasserstoff zu Silanmolekülen (SiH₄) verbinden.

Der Volumenbereich der Hohlkathodenentladung ist eine Funktion der Temperatur des Targetkopfs 60, der Höhe der EntladungsspannungderVerflüchtigungsspannungsquelle 44, des Innendrucks der Vakuumkammer 10 und des Durchsatzes an Reaktionsgas und Trägergas. Die Hohlkathodenentladung erstreckt sich je nach den vorgenannten äußeren Bedingungen über einen bestimmten Tiefenbereich der Furchen 62.

Die aus dem Reaktionsgas und dem Targetmaterial gebildete Transportverbindung Silan gelangt durch eine im wesentlichen ungerichtete Bewegung auch in die Nähe der Substrate 18, die in Fig. 1 dargestellt sind. In der Nähe der Substrate 18 herrscht die von der Entladungsspannungsquelle 24 erzeugte Hauptglimmentladung, die ein Aufbrechen der Transportverbindung Silan bewirkt, wobei sich das Silizium mit dem teilionisierten Reaktivgas Stickstoff verbindet und auf der Substratoberfläche eine Schicht Siliziumnitrid (Si₃N₄) bildet.

Durch die ungerichtete Verteilung des Silan in der Vakuumkammer 10 und der im wesentlichen omnidirektionellen Feldverteilung des elektrischen Feldes um die Substrate 18 ist eine ausreichende Beschichtung auch von zur Chargierplatte 16 hinweisenden Teilflächen der Substrate 18 sicher gewährleistet.

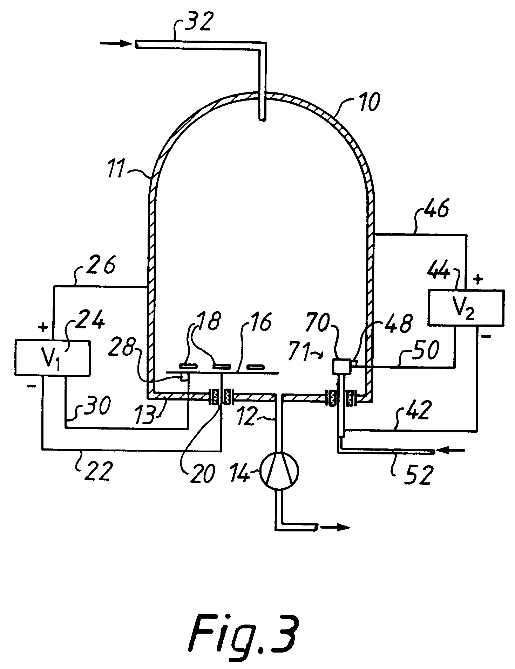

Die Fig. 3 zeigt eine schematische Querschnittsansicht einer Vorrichtung zum Hartstoffbeschichten gemäß einem zweiten Ausführungsbeispiel. Gleiche Merkmale tragen gleiche Bezugszeichen. Die Anordnung der Substrate 18, die Zuführung des Reaktivgases in Gestalt der Reaktivgasleitung 32 sowie die Entladungsspannungsquelle 24 zur Erzeugung der Hauptglimmentladung sind analog dem ersten Ausführungsbeispiel aufgebaut.

In Abwandlung zum ersten Ausführungsbeispiel ist in der Vakuumkammer 10 eine Hohlräume aufweisende Verflüchtigungselektrodenanordnung 70 vorgesehen, die sich elektrisch von der Vakuumkammer 10 isoliert durch den Boden 13 der Vakuumkammer 10 hindurcherstreckt. Die Verflüchtigungselektrodenanordnung 70 ist über die Verflüchtigungskathodenleitung 42 mit dem Minuspol der Verflüchtigungsspannungsquelle 44 verbunden. Der Pluspol der Verflüchtigungsspannungsquelle 44 ist über die Verflüchtigungsanodenleitung 46 an das Gehäuse 11 der Vakuumkammer 10 angeschlossen. Die Verflüchtigungsspannungsquelle 44 erzeugt analog wie im ersten Ausführungsbeispiel eine Nebenglimmentladung zwischen dem hohlen Kopf 71 der Verflüchtigungselektrodenanordnung 70 und der Vakuumkammer 10, bei der sich der hohle Kopf 71 der Verflüchtigungselektrodenanordnung 70 erhitzt. Die Temperatur des Kopfes 71 der hohlen Verflüchtigungselektrodenanordnung 70 wird mit Hilfe des Verflüchtigungsthermofühlers 48 erfaßt und über die Signalleitung 50 durch das Gehäuse 11 der Vakuumkammer 10 hindurch zur Temperaturregelung der Verflüchtigungsspannungsquelle 44 geleitet.

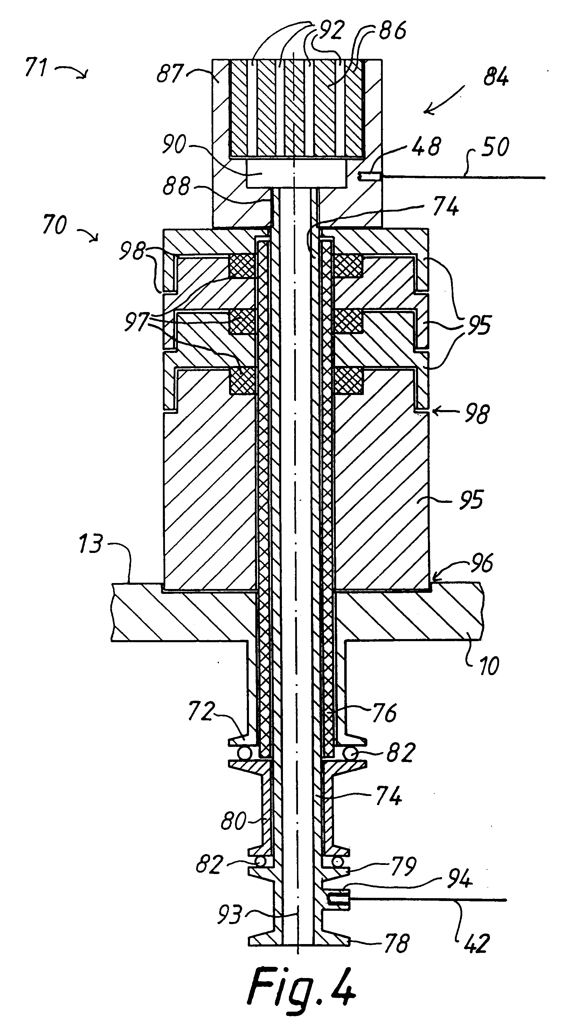

Die Reaktions- und Trägergasleitung 52 ist an die hohle Verflüchtigungselektrodenanordnung 70 angeschlossen, so daß das Reaktionsgas und das Trägergas durch die hohle Verflüchtigungselektrodenanordnung 70 bis zum Kopf 71 und durch diesen hindurch geblasen wird, was in der Fig. 4 deutlicher gezeigt ist.

Die Fig. 4 zeigt die hohle Verflüchtigungselektrodenanordnung 70 für die Vorrichtung gemäß Fig. 3. Die hohle Verflüchtigungselektrodenanordnung 70 erstreckt sich durch eine mit einem Flansch 72 versehene Öffnung im Boden 13 der Vakuumkammer 10 hindurch. Die hohle Verflüchtigungselektrodenanordnung 70 verfügt über ein Stahlrohr 74, das von einem isolierenden Keramikrohr 76 umgeben ist, dessen Außendurchmesser an die Öffnung im Boden 13 der Vakuumkammer 10 angepaßt ist.

Das Stahlrohr 74 verfügt über zwei Kleinflansche 78 und 79. An den außerhalb der Vakuumkammer 10 am Ende des Stahlrohrs 74 angeordneten Kleinflansch 78 ist die in der Fig. 4 nicht gezeichnete Reaktions- und Trägergasleitung 52 angeschlossen, die z.B. aus einem Plastikschlauch besteht. Damit ist diese Gaszuführung gegenüber der hohlen Verflüchtigungselektrodenanordnung 70 elektrisch isoliert. Der zwischen dem ersten Kleinflansch 78 und dem Boden der Vakuumkammer 10 angeordnete, zweite Kleinflansch 79 verbindet das Stahlrohr 74 über ein keramisches Zwischenstück 80 mechanisch mit dem Flansch 72 der Vakuumkammer 10 bei gleichzeitiger elektrischer Isolierung voneinander. Zwischen dem Zwischenstück 80 und den Flanschen 72 bzw. 79 sind O-Ringe 82 angeordnet. Die beiden Flanschübergänge 72 zu 79 und 78 zu 52 sind mit in der Zeichnung nicht dargestellten Schellen gesichert.

Durch das Stahlrohr 74 strömt das durch die Reaktions-und Trägergasleitung 52 zugeführte Gasgemisch aus Reaktions- und Trägergas zu einem im Kopf 71 ausgebildeten Elektrodenkopf 84, der aus einem gelochten Targetkopf 86 und einem Stahlbecher 87 besteht. Der Stahlbecher 87 weist in seinem Boden eine Öffnung mit einem Innengewinde 88 auf, so daß der Stahlbecher 87 auf das an dem dem Flansch 78 gegenüberliegenden Ende des Stahlrohrs 74 befindliche Außengewinde aufschraubbar ist.

In dem Stahlbecher 87 ist der Verflüchtigungsthermofühler 48 angeordnet, der an die Signalleitung 50 angeschlossen ist. Der zylindrische Stahlbecher 87 weist in Verlängerung seiner Bodenöffnung eine Becheröffnung auf, in die der Targetkopf 86 in elektrischer Verbindung im wesentlichen paßgenau eingesetzt ist. Zwischen der Becheröffnung und der Bodenöffnung des Stahlbechers 87 ist eine in ihrem Durchmesser zwischen den beiden vorgenannten Öffnungen liegende Vorkammer 90 vorgesehen. Die Vorkammer 90 gestattet eine erste Verwirbelung und Verteilung des eingeleiteten Gasgemisches, bevor es in Entladungskanälen oder -bohrungen 92 des Targetkopfs 86 eintritt.

Die Achsen der Entladungsbohrungen 92 im Targetkopf 86 verlaufen im wesentlichen parallel zur Achse 93 des Targetkopfs 86 und des Stahlrohrs 74. Der Stirnflächenanteil der Entladungsbohrungen 92 beläuft sich vorteilhafterweise auf 25 bis 50 Prozent der Gesamtstirnfläche des Targetkopfs 86. In der Zeichnung sind die Entladungsbohrungen 92 zur Vereinfachung als gleichgroße Bohrungen dargestellt. Vorteilhafterweise sind in den Targetkopf 86 als Entladungsbohrungen 92 Kanäle mit verschiedenen Durchmessern gebohrt, wobei die Durchmesser der Entladungsbohrungen 92 ungefähr zwischen unter 1 und 10 Millimetern liegen. Alternativ dazu können die Entladungsbohrungen 92 als konische Bohrungen ausgeführt sein, wobei sich ihr größerer Durchmesser an der zur Vakuumkammer 10 hinweisenden Stirnseite des Targetkopfs 86 befindet. Die Länge des Targetkopfs 86 parallel zu der Achse 90 ist kleiner als ungefähr 50 Durchmesser der größten Bohrung bzw. der größten Öffnung eines Bohrkonus.

Der Targetkopf 86 besteht aus dem Element des Schichtmaterials, das mit Hilfe der Transportverbindung chemisch an die Substrate 18 herantransportiert werden soll. über das Stahlrohr 74 ist der Targetkopf 86 mit dem elektrischen Anschluß 94 außerhalb der Vakuumkammer 10 verbunden, der über die Verflüchtigungskathodenleitung 42 mit dem Minuspol der Verflüchtigungsspannungsquelle 44 verbunden ist.

Durch das Anlegen einer Gleichspannung zwischen dem hohlen Targetkopf 84 und der Vakuumkammer 10 entsteht in den Entladungsbohrungen 92 des Targetkopfs 86 eine Hohlkathodenentladung. Die Ausdehnung der Hohlkathodenentladung ist eine Funktion der Temperatur des Targetkopfs 86, der Höhe der Entladungsspannung der Verflüchtigungsspannungsquelle 44, des Innendrucks der Vakuumkammer 10 und des Durchsatzes an Reaktionsgas und Trägergas. Die Hohlkathodenentladung zündet jeweils zuerst in den kleinsten Entladungsbohrungen 92 bzw. an den engsten Stellen der Bohrkoni der Entladungsbohrungen 92 und zündet bei steigender Spannung bzw. fortschreitender Pulsdauer in größeren Entladungsbohrungen 92 bzw. greift auf größere Durchmesser der Bohrkoni der Entladungsbohrungen 92 über.

Der Stahlbecher 87 ruht auf vier zylindrischen, mit einer Zentralbohrung versehenen Stahlzwischenstücken 95, von denen das dem Boden der Vakuumkammer 10 nächste Stahlzwischenstück 95 in einer Zentriervertiefung 96 angeordnet ist. Durch die Zentralbohrung erstreckt sich das mit dem isolierenden Keramikrohr 76 versehene Stahlrohr 74.

Die vier Stahlzwischenstücke 95 sind mit Hilfe von drei Ringen 97 aus Aluminiumoxid-Keramik voneinander elektrisch getrennt, so daß keine elektrische Verbindung zwischen dem obersten, den Stahlbecher 87 berührenden Stahlzwischenstück 95 und dem untersten, den Boden der Vakuumkammer 10 berührenden Stahlzwischenstück 95 besteht. Die Ringe 97 liegen in Aushöhlungen der Stahlzwischenstücke 95 an dem Keramikrohr 76 an. Spalte 98 zwischen den einzelnen Stahlzwischenstücken 95 in der Größenordnung von einem halben Millimeter verlaufen von den Ringen 97 aus in einer durch die Topfform der drei oberen Stahlzwischenstücke 95 begrenzten im Schnitt Z-förmigen Gestalt in den Innenraum der Vakuumkammer 10. Dadurch wird Material-Ablagerungen an den Ringen 97 entgegengewirkt, die einen Kurzschluß zwischen dem Targetkopf 86 und dem Boden der Vakuumkammer 10 hervorrufen könnten. Eine ähnliche Vakuumdurchführung ist für die Chargierelektrodendurchführung 20 vorgesehen.

Beispielhaft wird im folgenden die Erzeugung einer Schicht aus Borkarbid (B₄C) beschrieben. Das Targetmaterial des Targetkopfs 86 besteht in diesem Falle aus Bor. In den Targetkopf 86 ist eine Vielzahl von Entladungsbohrungen 92 eingebracht. Zwischen dem Gehäuse 11 der Vakuumkammer 10 und dem Targetkopf 86 herrscht eine große Potentialdifferenz, die bei dem herrschenden Druck und bei dem durch das Stahlrohr 74 zugeführten Argon-Wasserstoff-Gasgemisch zu einer Hohlkathodenentladung in den Entladungsbohrungen 92 des Targetkopfs 86 führt. Die schweren Argonatome schlagen Boratome aus dem Targetmaterial des Targetkopfs 86 in den Entladungsbohrungen 92 heraus, die sich in der Hohlkathodenentladung mit den Wasserstoffatomen des Reaktionsgases zu Diboran (B₂H₆) verbinden. Durch die Reaktivgasleitung 32 wird der Vakuumkammer 10 Methan zugeführt, so daß sich in der Hauptglimmentladung in unmittelbarer Umgebung der Substrate 18 die Transportverbindung Diboran und das Reaktivgas Methan zu einer Borkarbidbeschichtung auf den Substraten 18 verbinden.

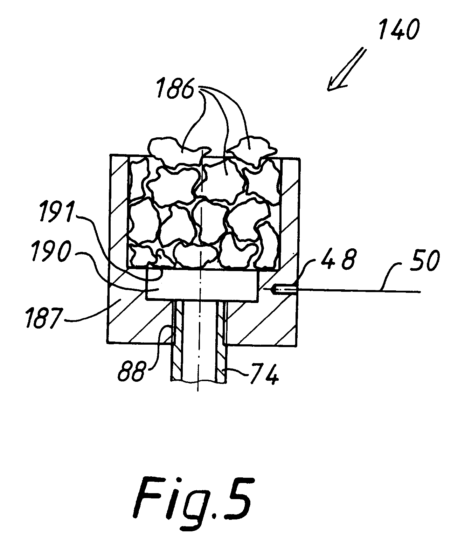

Die Fig. 5 zeigt vergrößert und in einer perspektivischen Ansicht das Kopfende einer Verflüchtigungselektrode 140 gemäß der in der Fig. 1 insgesamt dargestellten Vorrichtung bei einem dritten Ausführungsbeispiel. Die Verflüchtigungselektrode 140 verfügt über einen Targetkopfbehälter 187, der auf dem Stahlrohr 74 montiert ist, durch das das durch die Reaktions- und Trägergasleitung 52 zugeführte Gasgemisch aus Reaktions- und Trägergas strömt. Der Elektrodenkopf besteht aus einem hohlen Stahlbecher 187. Der Stahlbecher 187 weist in seinem Boden eine Öffnung mit einem Innengewinde 88 auf, so daß der Stahlbecher 187 auf das an dem dem Flansch 78 gegenüberliegenden Ende des Stahlrohrs 74 befindliche Außengewinde aufschraubbar ist.

In dem Stahlbecher 187 ist der Verflüchtigungsthermofühler 48 angeordnet, der an die Signalleitung 50 angeschlossen ist. Der zylindrische Stahlbecher 187 weist in Verlängerung seiner Bodenöffnung eine Becheröffnung auf, in die Schüttgut 186 in elektrischer Verbindung einbringbar ist. Das Schüttgut 186 kann aus unregelmäßig geformten Körnern, Brocken oder auch Kugeln aus dem zu verflüchtigenden Material bestehen.

Zwischen der Becheröffnung und der Bodenöffnung des Stahlbechers 187 ist eine in ihrem Durchmesser zwischen den beiden vorgenannten Öffnungen liegende Vorkammer 190 vorgesehen. Die Vorkammer 190 gestattet eine erste Verwirbelung und Verteilung des eingeleiteten Gasgemisches, bevor es durch ein Netzfilter 191 in das Schüttgut 186 eintritt. Das Netzfilter 191 bewirkt, daß nicht große Stücke des Schüttguts 186 in das Stahlrohr 74 fallen können. In einer anderen Ausgestaltung der Verflüchtigungselektrode 140, kann eine ableitende seitliche Öffnung im Stahlrohr 74 vorgesehen sein, durch die kleine Reststücke des sich verflüchtigenden und auflösenden Schüttguts 186 automatisch den Elektrodenbereich verlassen, so daß frisches Schüttgut 186 nachgefüllt werden kann.

Das Schüttgut 186 besteht aus dem Element des Schichtmaterials, das mit Hilfe der Transportverbindung chemisch an die Substrate 18 herantransportiert werden soll. Über das Stahlrohr 74 ist das Schüttgut 186 mit dem elektrischen Anschluß 94 außerhalb der Vakuumkammer 10 verbunden, der über die Verflüchtigungskathodenleitung 42 mit dem Minuspol der Verflüchtigungsspannungsquelle 44 verbunden ist.

Durch das Anlegen einer Gleichspannung zwischen dem hohlen Stahlbecher 187 und der Vakuumkammer 10 entsteht in den Zwischenräumen zwischen den Schüttgutstücken 186 eine Hohlkathodenentladung, die die Verflüchtigungsreaktion bewirkt. Die Ausdehnung der Hohlkathodenentladung ist eine Funktion der Temperatur des Stahlbechers 187 und des Schüttguts 186, der Höhe der Entladungsspannung der Verflüchtigungsspannungsquelle 44, des Innendrucks der Vakuumkammer 10 und des Durchsatzes an Reaktionsgas und Trägergas. Die Abmessungen der Körner, Brocken oder Kugeln können in allen Dimensionen z.B. zwischen 3 und 30 Millimetern betragen.

Insbesondere ist es mit der Verflüchtigungselektrode 140 gemäß Fig. 5 möglich, ohne eine Unterbrechung des Beschichtungsprozesses neues zu verflüchtigendes Material in den Stahlbecher 187 einzufüllen und verbrauchte Stücke automatisch zu entfernen.

## Patentansprüche

1. Verfahren zum Beschichten eines Substrates in einem Plasma, bei dem zum Transport nichtflüchtiger Substanzen in das Plasma einer abgeschlossenen Vakuumkammer in räumlicher Entfernung von der Anode das zu beschichtende Substrat als eine erste Kathode und eine zweite Kathode aus der zu transportierenden nichtflüchtigen Substanz als Verflüchtigungselektrode vorgesehen sind, mit den Verfahrensschritten
- des Evakuierens der Vakuumkammer und Einleitens eines Trägergases in die Vakuumkammer bei einem Druck von unter 1 kPa (10 mbar);
- des Einleitens eines Reaktivgases in die Vakuumkammer;
- des Erzeugens einer Potentialdifferenz zwischen der Anode und der ersten Kathode, um eine Hauptglimmentladung zu schaffen;
- des Erzeugens einer Potentialdifferenz zwischen der Anode und der zweiten Kathode, um eine Nebenglimmentladung zu schaffen; und
- des Umspülens der Verflüchtigungselektrode mit einem Gasgemisch aus einem Reaktionsgas und dem Trägergas, wobei die vom Trägergas in der Nebenglimmentladung aus der Verflüchtigungselektrode herausgelöste nichtflüchtige Substanz in einer chemischen Transportverbindung mit dem Reaktionsgas zu dem Substrat transportiert wird und im dortigen Plasma das Substrat mit einer chemischen Beschichtungsverbindung aus der nichtflüchtigen Substanz mit dem Reaktivgas beschichtet wird.

2. Verfahren nach Anspruch 1, gekennzeichnet durch die weiteren Verfahrensschritte des Beheizens des Substrates und des Haltens des Substrates auf einer Temperatur, die unter dem Schmelzpunkt des Materials des Substrates liegt, während die Glimmentladungen glühen.

3. Verfahren nach einem der vorstehenden Ansprüche, dadurch gekennzeichnet, daß das Umspülen der Verflüchtigungselektrode mit dem Gasgemisch aus dem Reaktionsgas und dem Trägergas durch ein Anblasen der Oberfläche der Verflüchtigungselektrode erfolgt.

4. Verfahren nach Anspruch 3, dadurch gekennzeichnet, daß das Gasgemisch in Furchen in der Oberfläche der Verflüchtigungselektrode geblasen wird.

5. Verfahren nach einem der Ansprüche 1 oder 2, dadurch gekennzeichnet, daß das Umspülen der Verflüchtigungselektrode mit dem Gasgemisch aus dem Reaktionsgas und dem Trägergas durch Hindurchblasen durch Kanäle oder Zwischenräume in der hohlen Verflüchtigungselektrodenanordnung erfolgt.

6. Verfahren nach einem der Ansprüche 1, 2 oder 5, dadurch gekennzeichnet, daß das die hohle Verflüchtigungselektrode füllende Schüttgut aus Brocken, Körnern oder Kugeln besteht.

7. Verfahren nach einem der Ansprüche 1, 2, 5 oder 6, dadurch gekennzeichnet, daß die Schüttgutstücke eine Größe zwischen 3 und 30 Millimeter in allen Richtungen aufweisen.

8. Verfahren nach einem der vorstehenden Ansprüche, dadurch gekennzeichnet, daß das Trägergas Argon, das Reaktivgas Stickstoff, das Reaktionsgas Wasserstoff ist und daß die Verflüchtigungselektrode aus Silizium besteht, wodurch als Transportverbindung Silan und als Beschichtungsmaterial Siliziumnitrid entsteht.

9. Verfahren nach einem der vorstehenden Ansprüche, dadurch gekennzeichnet, daß das Trägergas Argon, das Reaktivgas Methan und das Reaktionsgas Wasserstoff ist und daß die Verflüchtigungselektrode aus Silizium besteht, wodurch als Transportverbindung Silan und als Beschichtungsmaterial Siliziumcarbid entsteht.

10. Verfahren nach einem der vorstehenden Ansprüche, dadurch gekennzeichnet, daß das Trägergas Argon, das Reaktivgas Sauerstoff und das Reaktionsgas Wasserstoff ist und daß die Verflüchtigungselektrode aus Silizium besteht, wodurch als Transportverbindung Silan und als Beschichtungsmaterial Siliziumdioxid (Quarz) entsteht.

11. Verfahren nach einem der vorstehenden Ansprüche, dadurch gekennzeichnet, daß das Trägergas Argon, das Reaktivgas Stickstoff und das Reaktionsgas Wasserstoff ist und daß die Verflüchtigungselektrode aus Bor besteht, wodurch als Transportverbindung Diboran und als Beschichtungsmaterial kubisches Bornitrid entsteht.

12. Verfahren nach einem der vorstehenden Ansprüche, dadurch gekennzeichnet, daß das Trägergas Argon, das Reaktivgas Methan und das Reaktionsgas Wasserstoff ist und daß die Verflüchtigungselektrode aus Bor besteht, wodurch als Transportverbindung Diboran und als Beschichtungsmaterial Borkarbid entsteht.

13. Verfahren nach einem der vorstehenden Ansprüche, dadurch gekennzeichnet, daß das Trägergas Argon, das Reaktionsgas ein Gasgemisch aus Kohlendioxid und Methan und das Reaktivgas ein Inertgas ist und daß die Verflüchtigungselektrode aus Nickel besteht, wodurch als Transportverbindung Nickeltetracarbonyl und als Beschichtungsmaterial Nickel entsteht.

14. Verfahren nach einem der vorstehenden Ansprüche, dadurch gekennzeichnet, daß das Trägergas Argon, das Reaktionsgas ein Gasgemisch aus Kohlendioxid und Methan und das Reaktivgas Methan ist und daß die Verflüchtigungselektrode aus Chrom besteht, wodurch als Transportverbindung Chromtetracarbonyl und als Beschichtungsmaterial Chromkarbid entsteht.

15. Vorrichtung zur Beschichtung eines Substrates (18) in einem Plasma nach einem Verfahren gemäß einem der Ansprüche 1, 2 oder 5, mit einer abgeschlossenen Vakuumkammer (10), mit einer aus der zu transportierenden nichtflüchtigen Substanz hergestellten Verflüchtigungselektrodenanordnung (40, 70, 140), die eine Verflüchtigungselektrode (60, 86, 186) in räumlicher Entfernung von einer Gegenelektrode (11) und von einer Chargierplatte (16) für das Substrat (18) in der Vakuumkammer (10) umfaßt, mit einer Verflüchtigungsspannungsquelle (44) zur Erzeugung einer Potentialdifferenz zwischen der Gegenelektrode (11) und der Verflüchtigungselektrode (60, 86, 186), mit einer in die Vakuumkammer (10) mündende Reaktivgasleitung (32), durch die ein Reaktivgas in die Vakuumkammer (10) einleitbar ist, und mit einer in die Vakuumkammer (10) mündende Reaktionsgas- und Trägergasleitung (52), durch die ein Gasgemisch aus Reaktionsgas und Trägergas in die Vakuumkammer (10) derart einleitbar ist, daß die Verflüchtigungselektrodenanordnung (40, 70, 140) von dem Gasgemisch aus dem Reaktionsgas und dem Trägergas umspülbar ist, und mit einer Abscheidungseinrichtung (11, 16, 24) zur Abscheidung der zu transportierenden nichtflüchtigen Substanz auf dem Substrat (18), **dadurch gekennzeichnet,** daß die Abscheidungseinrichtung (11, 16, 24) die für das zu beschichtende Substrat (18) als eine Kathode vorgesehene Chargierplatte (16), die in räumlicher Entfernung von der als Anode gestalteten Gegenelektrode (11) in der Vakuumkammer (10) angeordnet ist, und eine Entladungsspannungsquelle (24) zur Erzeugung einer Potentialdifferenz zwischen der Anode (11) und der Kathode (16) umfaßt, daß die Verflüchtigungselektrode (60, 86) die Gestalt einer Hohlkathode aufweist, daß die Reaktionsgas- und Trägergasleitung (52) in eine Verteilerkammer (90) der Verflüchtigungselektrode (70, 87) mündet und daß der Targetkopf (87) der Verflüchtigungselektrode (70, 87) eine Vielzahl von Entladungskanälen (92) aufweist, wobei die Achsen der Entladungskanäle (92) im wesentlichen parallel zueinander verlaufen sowie die eine Mündung der Entladungskanäle (92) in die Vakuumkammer (10) und die andere Mündung der Entladungskanäle (92) in die Verteilerkammer (90) münden.

16. Vorrichtung nach Anspruch 15, dadurch gekennzeichnet, daß die Entladungskanäle (92) eine Vielzahl von verschiedenen Durchmessern aufweisen.

17. Vorrichtung nach Anspruch 15, dadurch gekennzeichnet, daß die Entladungskanäle (92) ausgebohrte Kegelstümpfe sind, bei denen die kleineren Durchmesser der Reaktionsgas- und Trägergasleitung (52) zugewandt sind.

18. Vorrichtung nach Anspruch 16 oder 17, dadurch gekennzeichnet, daß die Durchmesser der Entladungskanäle (92) zwischen einem und zehn Millimetern liegen.

19. Vorrichtung nach einem der Ansprüche 16 bis 18, dadurch gekennzeichnet, daß die Länge des Targetkopfs (86) kleiner als ungefähr 50 Durchmesser der größten Bohrung bzw. der größten Öffnung eines Kegelstumpfes ist.

20. Vorrichtung zur Beschichtung eines Substrates (18) in einem Plasma nach einem Verfahren gemäß einem der Ansprüche 1, 2 oder 5 bis 7, mit einer abgeschlossenen Vakuumkammer (10), mit einer aus der zu transportierenden nichtflüchtigen Substanz hergestellten Verflüchtigungselektrodenanordnung (40, 70, 140), die eine Verflüchtigungselektrode (60, 86, 186) in räumlicher Entfernung von einer Gegenelektrode (11) und von einer Chargierplatte (16) für das Substrat (18) in der Vakuumkammer (10) umfaßt, mit einer Verflüchtigungsspannungsquelle (44) zur Erzeugung einer Potentialdifferenz zwischen der Gegenelektrode (11) und der Verflüchtigungselektrode (60, 86, 186), mit einer in die Vakuumkammer (10) mündende Reaktivgasleitung (32), durch die ein Reaktivgas in die Vakuumkammer (10) einleitbar ist, und mit einer in die Vakuumkammer (10) mündende Reaktionsgas- und Trägergasleitung (52), durch die ein Gasgemisch aus Reaktionsgas und Trägergas in die Vakuumkammer (10) derart einleitbar ist, daß die Verflüchtigungselektrodenanordnung (40, 70, 140) von dem Gasgemisch aus dem Reaktionsgas und dem Trägergas umspülbar ist, und mit einer Abscheidungseinrichtung (11, 16, 24) zur Abscheidung der zu transportierenden nichtflüchtigen Substanz auf dem Substrat (18), **dadurch gekennzeichnet,** daß die Abscheidungseinrichtung (11, 16, 24) die für das zu beschichtende Substrat (18) als eine Kathode vorgesehene Chargierplatte (16), die in räumlicher Entfernung von der als Anode gestalteten Gegenelektrode (11) in der Vakuumkammer (10) angeordnet ist, und eine Entladungsspannungsquelle (24) zur Erzeugung einer Potentialdifferenz zwischen der Anode (11) und der Kathode (16) umfaßt, daß die Verflüchtigungselektrode (60, 86, 186) die Gestalt einer Hohlkathode aufweist, daß die Reaktionsgas- und Trägergasleitung (52) in eine Verteilerkammer (190) der Verflüchtigungselektrode (140) mündet und daß der Targetkopf (187) der Verflüchtigungselektrode (140) mit Schüttgut (186) aus dem zu verflüchtigenden Material füllbar ist, wobei das Reaktions- und Trägergas in dem Hohlkathodenbereich zwischen den einzelnen Stücken des Schüttguts (186) in die Vakuumkammer (10) einleitbar ist.

21. Vorrichtung zur Beschichtung eines Substrates (18) in einem Plasma nach einem Verfahren gemäß einem der Ansprüche 1 bis 4, mit einer abgeschlossenen Vakuumkammer (10), mit einer aus der zu transportierenden nichtflüchtigen Substanz hergestellten Verflüchtigungselektrodenanordnung (40, 70), die eine Verflüchtigungselektrode (60, 86) in räumlicher Entfernung von einer Gegenelektrode (11) und von einer Chargierplatte (16) für das Substrat (18) in der Vakuumkammer (10) umfaßt, mit einer Verflüchtigungsspannungsquelle (44) zur Erzeugung einer Potentialdifferenz zwischen der Gegenelektrode (11) und der Verflüchtigungselektrode (60, 86), mit einer in die Vakuumkammer (10) mündende Reaktivgasleitung (32), durch die ein Reaktivgas in die Vakuumkammer (10) einleitbar ist, und mit einer in die Vakuumkammer (10) mündende Reaktionsgas- und Trägergasleitung (52), durch die ein Gasgemisch aus Reaktionsgas und Trägergas in die Vakuumkammer (10) derart einleitbar ist, daß die Verflüchtigungselektrodenanordnung (40, 70) von dem Gasgemisch aus dem Reaktionsgas und dem Trägergas umspülbar ist, und mit einer Abscheidungseinrichtung (11, 16, 24) zur Abscheidung der zu transportierenden nichtflüchtigen Substanz auf dem Substrat (18), **dadurch gekennzeichnet,** daß die Abscheidungseinrichtung (11, 16, 24) die für das zu beschichtende Substrat (18) als eine Kathode vorgesehene Chargierplatte (16), die in räumlicher Entfernung von der als Anode gestalteten Gegenelektrode (11) in der Vakuumkammer (10) angeordnet ist, und eine Entladungsspannungsquelle (24) zur Erzeugung einer Potentialdifferenz zwischen der Anode (11) und der Kathode (16) umfaßt, daß die Verflüchtigungselektrode (60, 86) die Gestalt einer Hohlkathode aufweist, daß die Reaktionsgas- und Trägergasleitung (52) in einen Verteilertrichter (66) mündet, daß die Verflüchtigungselektrode (40) einen Targetkopf (60) mit einer gefurchten Oberfläche aufweist, wobei die Furchen (62) parallel nebeneinander verlaufen und im Querschnitt zu ihrer Längsrichtung spitz zulaufen, so daß in einer Querschnittsansicht jeweils Dreiecke sichtbar sind, und daß die Höhe des Verteilertrichters (66) die Tiefe der Furchen (62) und die Breite des Verteilertrichters (66) die Breite der Gesamtheit der nebeneinander verlaufenden Furchen (62) aufweist, wobei der Verteilertrichter (66) in Verlängerung der Furchen (62) des Targetkopfs (60) in der Ebene der Furchen (62) angeordnet ist.

22. Vorrichtung nach einem der Ansprüche 15 bis 21, dadurch gekennzeichnet, daß mit mindestens einer der Spannungsquellen (24, 44) eine gepulste Glimmentladungsspannung erzeugbar ist.

23. Vorrichtung nach Anspruch 22, dadurch gekennzeichnet, daß mit mindestens einer der Spannungsquellen (24, 44) eine Pulsdauer der gepulsten Glimmentladungen im Bereich von 20 bis 1000 Mikrosekunden und eine Pausendauer im Bereich von 20 bis 1000 Mikrosekunden erzeugbar ist.

24. Vorrichtung nach Anspruch 23, dadurch gekennzeichnet, daß mit den Spannungsquellen (24, 44) bei vorbestimmter Pausendauer die Temperatur des Substrates (18) bzw. der Verflüchtigungselektrode (70) durch die Länge der Pulsdauern der gepulsten Glimmentladungen einstellbar ist.

## Claims

1. A process for coating a substrate in a plasma wherein for transportation of non-volatile substances into the plasma of a closed vacuum chamber at a spatial distance from the anode the substrate to be coated is provided as a first cathode and a second cathode comprising the non-volatile substance to be transported is provided as a volatilisation electrode, comprising the process steps of:
- evacuating the vacuum chamber and introducing a carrier gas into the vacuum chamber at a pressure of below 1kPa (10 mbar);
- introducing a reactive gas into the vacuum chamber;
- producing a potential difference between the anode and the first cathode to create a primary glow discharge;
- producing a potential difference between the anode and the second cathode to create a secondary glow discharge; and
- passing a gas mixture comprising a reaction gas and the carrier gas around the volatilisation electrode, wherein the non-volatile substance which is removed from the volatilisation electrode by the carrier gas in the secondary glow discharge is transported in a chemical transport compound with the reaction gas to the substrate and in the plasma there the substrate is coated with a chemical coating compound comprising the non-volatile substance with the reactive gas.

2. A process according to claim 1 characterised by the further process steps of heating the substrate and holding the substrate at a temperature which is below the melting point of the material of the substrate while the glow discharges glow.

3. A process according to one of the preceding claims characterised in that the step of passing the gas mixture comprising the reaction gas and the carrier gas around the volatilisation electrode is effected by blowing it against the surface of the volatilisation electrode.

4. A process according to claim 3 characterised in that the gas mixture is blown into channels in the surface of the volatilisation electrode.

5. A process according to one of claims 1 and 2 characterised in that the step of passing the gas mixture comprising the reaction gas and the carrier gas around the volatilisation electrode is effected by blowing it through passages or intermediate spaces in the hollow volatilisation electrode arrangement.

6. A process according to one of claims 1, 2 and 5 characterised in that the loose material filling the hollow volatilisation electrode comprises fragments, grains or balls.

7. A process according to one of claims 1, 2, 5 and 6 characterised in that the pieces of loose material are of a size of between 3 and 30 millimetres in all directions.

8. A process according to one of the preceding claims characterised in that the carrier gas is argon, the reactive gas is nitrogen and the reaction gas is hydrogen and that the volatilisation electrode comprises silicon whereby silane is produced as the transport compound and silicon nitride is produced as the coating material.

9. A process according to one of the preceding claims characterised in that the carrier gas is argon, the reactive gas is methane and the reaction gas is hydrogen and that the volatilisation electrode comprises silicon whereby silane is produced as the transport compound and silicon carbide is produced as the coating material.

10. A process according to one of the preceding claims characterised in that the carrier gas is argon, the reactive gas is oxygen and the reaction gas is hydrogen and that the volatilisation electrode comprises silicon whereby silane is produced as the transport compound and silicon dioxide (quartz) is produced as the coating material.

11. A process according to one of the preceding claims characterised in that the carrier gas is argon, the reactive gas is nitrogen and the reaction gas is hydrogen and that the volatilisation electrode comprises boron whereby diborane is produced as the transport compound and cubic boron nitride is produced as the coating material.

12. A process according to one of the preceding claims characterised in that the carrier gas is argon, the reactive gas is methane and the reaction gas is hydrogen and that the volatilisation electrode comprises boron whereby diborane is produced as the transport compound and boron carbide is produced as the coating material.

13. A process according to one of the preceding claims characterised in that the carrier gas is argon, the reaction gas is a gas mixture of carbon dioxide and methane and the reactive gas is an inert gas and that the volatilisation electrode comprises nickel whereby nickel tetracarbonyl is produced as the transport compound and nickel is produced as the coating material.

14. A process according to one of the preceding claims characterised in that the carrier gas is argon, the reaction gas is a gas mixture of carbon dioxide and methane and the reactive gas is methane and that the volatilisation electrode comprises chromium whereby chromium tetracarbonyl is produced as the transport compound and chromium carbide is produced as the coating material.

15. Apparatus for coating a substrate (18) in a plasma in accordance with a process as set forth in one of claims 1, 2 and 5, comprising a closed vacuum chamber (10), a volatilisation electrode arrangement (40, 70, 140) which is produced from the non-volatile substance to be transported and which includes a volatilisation electrode (60, 86, 186) at a spatial distance from a counter-electrode (11) and a charging plate (16) for the substrate (18) in the vacuum chamber (10), a volatilisation voltage source (44) for producing a potential difference between the counter-electrode (11) and the volatilisation electrode (60, 86, 186), a reactive gas conduit (32) which opens into the vacuum chamber (10) and through which a reactive gas can be introduced into the vacuum chamber (10), and a reaction gas and carrier gas conduit (52) which opens into the vacuum chamber (10) and through which a gas mixture comprising reaction gas and carrier gas can be introduced into the vacuum chamber (10) in such a way that the gas mixture comprising the reaction gas and the carrier gas can flow around the volatilisation electrode arrangement (40, 70, 140), and a deposition device (11, 16, 24) for deposition on the substrate (18) of the non-volatile substance to be transported, characterised in that the deposition device (11, 16, 24) includes the charging plate (16) which is provided for the substrate (18) to be coated as a cathode and which is arranged at a spatial distance from the counter-electrode (11) which is in the form of the anode in the vacuum chamber (10) and a discharge voltage source (24) for producing a potential difference between the anode (11) and the cathode (16), that the volatilisation electrode (60, 86) is in the form of a hollow cathode, that the reaction gas and carrier gas conduit (52) opens into a distributor chamber (90) of the volatilisation electrode (70, 87) and that the target head (86) of the volatilisation electrode (70, 87) has a multiplicity of discharge passages (92), wherein the axes of the discharge passages (92) extend substantially parallel to each other and the one mouth openings of the discharge passages (92) open into the vacuum chamber (10) and the other mouth openings of the discharge passages (92) open into the distributor chamber (90).

16. Apparatus according to claim 15 characterised in that the discharge passages (92) are of a multiplicity of different diameters.

17. Apparatus according to claim 15 characterised in that the discharge passages (92) are bored-out truncated cones in which the smaller diameters are towards the reaction gas and carrier gas conduit (52).

18. Apparatus according to claim 16 or claim 17 characterised in that the diameters of the discharge passages (92) are between 1 and 10 millimetres.

19. Apparatus according to one of claims 16 to 18 characterised in that the length of the target head (86) is smaller than about 50 diameters of the largest bore or the largest opening of a truncated cone.

20. Apparatus for coating a substrate (18) in a plasma in accordance with a process as set forth in one of claims 1, 2 or 5 to 7, comprising a closed vacuum chamber (10), a volatilisation electrode arrangement (40, 70, 140) which is produced from the non-volatile substance to be transported and which includes a volatilisation electrode (60, 86, 186) at a spatial distance from a counter-electrode (11) and a charging plate (16) for the substrate (18) in the vacuum chamber (10), a volatilisation voltage source (44) for producing a potential difference between the counter-electrode (11) and the volatilisation electrode (60, 86, 186), a reactive gas conduit (32) which opens into the vacuum chamber (10) and through which a reactive gas can be introduced into the vacuum chamber (10), and a reaction gas and carrier gas conduit (52) which opens into the vacuum chamber (10) and through which a gas mixture comprising reaction gas and carrier gas can be introduced into the vacuum chamber (10) in such a way that the gas mixture comprising the reaction gas and the carrier gas can flow around the volatilisation electrode arrangement (40, 70, 140), and a deposition device (11, 16, 24) for deposition on the substrate (18) of the non-volatile substance to be transported, characterised in that the deposition device (11, 16, 24) includes the charging plate (16) which is provided for the substrate (18) to be coated as a cathode and which is arranged at a spatial distance from the counter-electrode (11) in the form of an anode in the vacuum chamber (10), and a discharge voltage source (24) for producing a potential difference between the anode (11) and the cathode (16), that the volatilisation electrode (60, 86, 186) is in the form of a hollow cathode, that the reaction gas and carrier gas conduit (52) opens into a distributor chamber (190) of the volatilisation electrode (140), and that the target head (187) of the volatilisation electrode (140) can be filled with loose fill (186) comprising the material to be volatilised, wherein the reaction and carrier gas can be introduced into the vacuum chamber (10) in the hollow cathode region between the individual pieces of the loose fill material (186).

21. Apparatus for coating a substrate (18) in a plasma in accordance with a process as set forth in one of claims 1 to 4, comprising a closed vacuum chamber (10), a volatilisation electrode arrangement (40, 70) which is produced from the non-volatile substance to be transported and which includes a volatilisation electrode (60, 86) at a spatial distance from a counter-electrode (11) and a charging plate (16) for the substrate (18) in the vacuum chamber (10), a volatilisation voltage source (44) for producing a potential difference between the counter-electrode (11) and the volatilisation electrode (60, 86), a reactive gas conduit (32) which opens into the vacuum chamber (10) and through which a reactive gas can be introduced into the vacuum chamber (10), and a reaction gas and carrier gas conduit (52) which opens into the vacuum chamber (10) and through which a gas mixture comprising reaction gas and carrier gas can be introduced into the vacuum chamber (10) in such a way that the gas mixture comprising the reaction gas and the carrier gas can flow around the volatilisation electrode arrangement (40, 70), and a deposition device (11, 16, 24) for deposition on the substrate (18) of the non-volatile substance to be transported, characterised in that the deposition device (11, 16, 24) includes the charging plate (16) which is provided for the substrate (18) to be coated as a cathode and which is arranged at a spatial distance from the counter-electrode (11) in the form of an anode in the vacuum chamber (10), and a discharge voltage source (24) for producing a potential difference between the anode (11) and the cathode (16), that the volatilisation electrode (60, 86) is in the form of a hollow cathode, that the reaction gas and carrier gas conduit (52) opens into a distributor funnel (66), that the volatilisation electrode (40) has a target head (60) with a channelled surface, wherein the channels (62) extend in parallel side-by-side relationship and acutely converge in cross-section relative to their longitudinal direction so that respective triangles can be seen in a cross-sectional view, and that the height of the distributor funnel (66) is of the depth of the channels (62) and the width of the distributor funnel (66) is of the width of the entirety of the channels (62) which extend side-by-side, wherein the distributor funnel (66) is arranged in line with the channels (62) in the target head (60) in the plane of the channels (62).

22. Apparatus according to one of claims 15 to 21 characterised in that a pulsed glow discharge voltage can be produced with at least one of the voltage sources (24, 44).

23. Apparatus according to claim 22 characterised in that a pulse duration of the pulsed glow discharges in the range of 20 to 1000 microseconds and a space duration in the range of 20 to 1000 microseconds can be produced with at least one of the voltage sources (24, 44).

24. Apparatus according to claim 23 characterised in that the temperature of the substrate (18) or the volatilisation electrode (70) can be adjusted by the length of the pulse durations of the pulsed glow discharges with the voltage sources (24, 44) when there is a predetermined space duration.

## Revendications

1. Procédé, pour revêtir un substrat dans un plasma, par lequel, pour transporter des substances non volatilisées dans le plasma d'une chambre à vide étanche et séparée de l'anode, sont prévus un substrat à revêtir formant première cathode et une deuxième cathode en matériau non volatilisé à transporter formant électrode de volatilisation, procédé comportant les étapes suivantes :
- évacuation de l'air de la chambre à vide et injection d'un gaz de transport dans la chambre à vide sous une pression de moins de 1KPa (10 mbar) ;
- injection d'un gaz réactif dans la chambre à vide,
- application d'une différence de potentiel entre l'anode et la première cathode, afin de réaliser une décharge principale,
- application d'une différence de potentiel entre l'anode et la deuxième cathode afin de réaliser une décharge secondaire,
- lavage de l'électrode de volatilisation avec un mélange de gaz de réaction et de gaz de transport, par lequel le matériau non volatilisé est extrait de l'électrode de volatilisation avec le gaz de transport de la décharge secondaire, et transporté au substrat dans un composé chimique de transport du gaz de réaction et par lequel dans le plasma, le substrat est revêtu d'un composé chimique de revêtement extrait du matériau non volatilisé avec le gaz réactif.

2. Procédé selon la revendication 1, caractérisé en ce qu'il comporte des étapes ultérieures de chauffage du substrat et de son maintient à une température située en dessous du point de fusion du substrat pendant que se produisent les décharges.

3. Procédé selon l'une des revendications précédentes, caractérisé en ce que, le lavage de l'électrode de volatilisation avec un mélange de gaz composé de gaz de réaction et de gaz de transport est produit par un soufflage de la surface supérieure de l'électrode de volatilisation.

4. Procédé selon la revendication 3 caractérisé en ce que le mélange de gaz est soufflé dans les rainures de la surface supérieure de l'électrode de volatilisation.

5. Procédé selon l'une des revendications 1 à 2, caractérisé en ce que le lavage de l'électrode de volatilisation avec le mélange de gaz composé de gaz de réaction et de gaz de transport est produit par soufflage dans les canaux ou les intervalles du dispositif creux d'électrode de volatilisation.

6. Procédé selon l'une des revendications 1, 2 ou 5 caractérisé en ce que l'électrode creuse de volatilisation est composée de matériau fragmenté en cailloux, grains ou billes.

7. Procédé selon l'une des revendications 1, 2, 5 ou 6 caractérisé en ce que les morceaux de matériau fragmenté mesurent entre 3 et 30 millimètres dans toutes les directions.

8. Procédé selon l'une des revendications précédentes, caractérisé en ce que le gaz de transport est de l'argon, le gaz réactif est de l'azote, le gaz de réaction est de l'hydrogène, et en ce que l'électrode de volatilisation est formée de silicium, entraînant la formation de silane comme composé de transport et de nitrure de silicium comme matériau de revêtement.

9. Procédé selon l'une des revendications précédentes caractérisé en ce que le gaz de transport est de l'argon, le gaz réactif est du méthane et le gaz de réaction est de l'hydrogène, et en ce que l'électrode de volatilisation est formée de silicium, entraînant la formation de silane comme composé de transport et de carbure de silicium comme matériau de revêtement.

10. Procédé selon l'une des revendications précédentes, carcatérisé en ce que le gaz de transport est de l'argon, le gaz réactif est de l'oxygène et le gaz de réaction est de l'hydrogène, et en ce que l'électrode de volatilisation est formée de silicium, entraînant la formation de silane comme composé de transport et de dioxyde de silicium (quartz) comme matériau de revêtement.

11. Procédé selon l'une des revendications précédentes caractérisé en ce que le gaz de transport est de l'argon le gaz réactif est de l'azote, le gaz de réaction est de l'hydrogène, et en ce que l'électrode de volatilisation est formée de bore, entraînant la formation de diborane comme composé de transport et de nitrure de bore cubique comme matériau de revêtement.

12. Procédé selon l'une des revendications précédentes caractérisé en ce que le gaz de transport est de l'argon, le gaz réactif est du méthane, le gaz de réaction est de l'hydrogène, et en ce que l'électrode de volatilisation est formée de bore, entraînant la formation de diborane comme composé de transport et de carbure de bore comme matériau de revêtement.

13. Procédé selon l'une des revendications précédentes, caractérisé en ce que le gaz de transport est de l'argon, le gaz de réaction est un mélange de dioxyde de carbone et de méthane, le gaz réactif est un gaz inerte et en ce que l'électrode de volatilisation est formée de nickel, entraînant la formation de carbonyle de nickel comme composé de transport et de nickel comme matériau de revêtement.

14. Procédé selon l'une des revendications précédentes caractérisé en ce que le gaz de transport est de l'argon, le gaz de réaction est un mélange de dioxyde de carbone et de méthane, le gaz réactif est du méthane, et en ce que l'électrode de volatilisation est formée de chrome, entraînant la formation de carbonyle de chrome comme composé de transport et de carbure de chrome comme matériau de revêtement.

15. Dispositif pour revêtir un substrat dans un plasma, au moyen d'un procédé selon l'une des revendications 1, 2 ou 5,
. avec une chambre à vide étanche (10), comportant un moyen formant électrode de volatilisation (40, 70, 140) réalisé dans un matériau non volatilise à transporter, et une électrode de volatilisation (60, 86, 186) maintenue à distance d'une contre-électrode (11) et d'une plaque de charge (16) pour le substrat (18),
. avec une source d'énergie de volatilisation (44) pour appliquer une différence de potentiel entre la contre-électrode (11) et l'électrode de volatilisation (60, 86, 186),
. avec une canalisation de gaz réactif (32) débouchant dans la chambre à vide (10) et au moyen de laquelle un gaz réactif est introduit dans la chambre à vide (10),
. avec une canalisation de gaz de réaction et de gaz de transport débouchant dans la chambre à vide (10), au moyen de laquelle un mélange de gaz de réaction et de gaz de transport est introduit dans la chambre à vide (10), pour laver le moyen formant électrode de volatilisation (40, 70, 140) avec le mélange de gaz de réaction et de gaz de transport,
. avec dispositif séparateur (11, 16, 24) pour séparer la matière non volatilisée à transporter sur le substrat (18),
caractérisé en ce que le dispositif séparateur (11, 16, 24) comporte une plaque de charge (18) comme cathode pour le substrat (18) à revêtir laquelle est séparée de la contre électrode formant anode et comporte une source d'énergie (24) pour établir une différence de potentiel entre l'anode (11) et la cathode (16),
- en ce que l'éléctrode de volatilisation (60, 86) présente la forme d'une électrode creuse,
- en ce que la canalisation de gaz de réaction et de gaz de transport (52) débouche dans une chambre de distribution (90) de l'électrode de volatilisation (70, 87),
- en ce que la tête cible (87) de l'électrode de volatilisation (70, 87) présente une pluralité de canaux de décharge (92), d'axes parallèles entre eux, de façon à déboucher d'une part dans la chambre à vide (10) et d'autre part dans la chambre de distribution (90).

16. Dispositif selon la revendication 15, caractérisé en ce que les canaux de décharge (92) présentent une pluralité de diamètres différents.

17. Dispositif selon la revendication 15, caractérisé en ce que les canaux de décharge (92) sont des tubes tronconiques dont les plus petits diamètres sont reliés la canalisation (52) de gaz de réaction et de gaz de transport.

18. Dispositif selon la revendication 16 ou 17 caractérisé en ce que les diamètres des canaux de décharge (92) varient entre un et dix millimètres.

19. Dispositif selon l'une des revendications 16 à 18 caractérisé en ce que la longueur de la tête cible (86) est inférieure à environ cinquante fois le diamètre du plus grand tube et en particulier de la plus grande ouverture d'un tube tronconique.

20. Dispositif pour revêtir un substrat (18) dans un plasma au moyen d'un procédé selon l'une des revendications 1, 2 ou 5 à 7,
. avec une chambre à vide, étanche 10,
comportant un moyen formant électrode de volatilisation (40, 70, 140) réalisé dans un matériau non volatilisé à transporter, et une électrode de volatilisation (60, 86, 186) maintenue à distance d'une contre-électrode (11) et d'une plaque de charge (16) pour le substrat (18),
. avec une source d'énergie de volatilisation (44) pour appliquer une différence de potentiel entre la contre-électrode (11) et l'électrode de volatilisation (60, 86, 186),
. avec une canalisation du gaz réactif (32) débouchant dans la chambre à vide (10) et au moyen de laquelle un gaz réactif est introduit dans la chambre à vide (10),
. avec une canalisation du gaz de réaction et de gaz de transport débouchant dans la chambre à vide (10), au moyen de laquelle un mélange de gaz de réaction et de gaz de transport est introduit dans la chambre à vide (10), pour laver le moyen formant électrode de volatilisation (40, 70, 140) avec le mélange de gaz de réaction et de gaz de transport,
. avec un dispositif séparateur (11, 16, 24) pour séparer la matière non volatilisée à transporter sur le substrat (18),
caractérisé en ce que le dispositif séparateur (11, 16, 24) comporte une plaque de charge (18) comme cathode pour le substrat (18) à revêtir laquelle est séparée de la contre électrode formant anode et comporte une source d'énergie (24) pour établir une différence de potentiel entre l'anode (11) et la cathode (16),
- en ce que l'électrode de volatilisation (60, 86, 186) présente la forme d'une électrode creuse,
- en ce que la canalisation de gaz de réaction et de gaz de transport (52) débouche dans une chambre de distribution (190) de l'électrode de volatilisation (140),
- en ce que la tête cible (187) de l'électrode de volatilisation (140) est remplie de matériau volatilisable, de sorte que le gaz de réaction et le gaz de transport sont introduits dans la chambre à vide (10), dans la région de la cathode en charbon entre les morceaux du matériau fragmentaire (186).

21. Dispositif pour revêtir un substrat (18) dans un plasma au moyen d'un procédé selon l'une des revendications 1 à 4,
. avec une chambre à vide étanche (10), comportant un moyen formant électrode de volatilisation (40, 70) réalisé dans un matériau non volatilisé à transporter, et une électrode de volatilisation (60, 86) maintenue à distance d'une contre-électrode (11) et d'une plaque de charge (16) pour le substrat (18),
. avec une source d'énergie de volatilisation (44) pour appliquer une différence de potentiel entre la contre-électrode (11) et l'électrode de volatilisation (60, 86),
. avec une canalisation de gaz réactif (32) débouchant dans la chambre à vide (10) et au moyen de laquelle un gaz réactif est introduit dans la chambre à vide (10),
. avec une canalisation de gaz réactif et de gaz de transport débouchant dans la chambre à vide (10), au moyen de laquelle un mélange de gaz de réaction, et de gaz de transport est introduit dans la chambre à vide (10), pour laver le moyen formant électrode de volatilisation (40, 70) avec le mélange de gaz de réaction et de gaz de transport,
. avec un dispositif séparateur (11, 16, 24) pour séparer la matière non volatilisée à transporter sur le substrat (18), caractérisé en ce que le dispositif séparateur (11, 16, 24) comporte une plaque de charge (18) comme cathode pour le substrat (18) à revêtir laquelle est séparée de la contre électrode formant anode et comporte une source d'énergie (24) pour établir une différence de potentiel entre l'anode (11) et la cathode (16),
- en ce que l'électrode de volatilisation (60, 86) présente la forme d'une électrode creuse,
- en ce que la canalisation de gaz de réaction et de gaz de transport (52) débouche dans un entonnoir de séparation (66),
- en ce que l'électrode de volatilisation (40) présente une tête cible (60) avec une surface supérieure rainurée où les rainures (62) sont parallèles entre elles, et présentent une section transversale pointue, formant en coupe transversale un triangle,
- et en ce que la hauteur de l'entonnoir de séparation (66) présente la profondeur des rainures (62), et sa largeur présente la largeur de l'ensemble des rainures (62) côte à côte, pour que ledit entonnoir (66) soit placé dans le prolongement et dans le plan des rainures (62) de la tête cible (60).

22. Dispositif selon l'une des revendications 15 à 21, caractérisé en ce que, une tension de décharge électrique pulsatoire est générée par au moins une des sources de tension (24, 44).

23. Dispositif selon la revendication 22 caractérisé en ce qu'une impulsion de la décharge électrique durant environ 20 à 1000 micro-secondes et une pause durant environ 20 à 1000 micro-secondes sont générées par au moins une des sources de tension (24, 44).

24. Dispositif selon la revendication 23, caractérisé en ce que la température du substrat (18) et respectivement de l'électrode de volatilisation (70) est réglable pendant la durée des décharges électriques pulsatoires au moyen des durées prédéterminées des pauses des sources de tension (24, 44).
